# EUROPÄISCHE PATENTSCHRIFT

(11) **EP 1 592 076 B1**
(45) Veröffentlichungstag und Bekanntmachung des Hinweises auf die Patenterteilung: **10.06.2009**
(21) Anmeldenummer: 05008670.1
(22) Anmeldetag: 20.04.2005
(51) Int. Cl.: H01L 33/00

(54) **Optoelektronisches Bauelement mit mehreren Stromaufweitungsschichten und Verfahren zu dessen Herstellung**
Optoelectronic device with several current spreading layers and its method of fabrication
Dispositif optoélectronique à plusieurs couches de diffusion de courant

(30) Priorität: 25.05.2004 DE 102004025610; 30.04.2004 DE 102004021419
(43) Veröffentlichungstag der Anmeldung: 02.11.2005
(73) Patentinhaber: OSRAM Opto Semiconductors GmbH, 93055 Regensburg (DE)
(72) Erfinder: Eberhard, Franz, 93059 Regensburg (DE); Strauss, Uwe, 93077 Bad Abbach (DE); Zehnder, Ulrich, 93049 Regensburg (DE); Oberschmid, Raimund, 93161 Sinzing (DE); Weimar, Andreas, 93049 Regensburg (DE)
(74) Vertreter: Epping - Hermann - Fischer

(56) Entgegenhaltungen:
- US-A1- 2002 036 286
- US-A1- 2004 266 044
- HYUNSOO KIM ET AL: "Design and Fabrication of Highly Efficient GaN-Based Light-Emitting Diodes" IEEE TRANSACTIONS ON ELECTRON DEVICES, IEEE SERVICE CENTER, PISACATAWAY, NJ, US, Bd. 49, Nr. 10, Oktober 2002 (2002-10), XP011072372 ISSN: 0018-9383
- SHYI-MING PAN ET AL: "Enhanced Output Power of InGaN-GaN Light-Emitting Diodes With High-Transparency Nickel-Oxide-Indium-Tin-OxideOhmic Contacts" IEEE PHOTONICS TECHNOLOGY LETTERS, IEEE SERVICE CENTER, PISCATAWAY, NJ, US, Bd. 15, Nr. 5, Mai 2003 (2003-05), XP011067688 ISSN: 1041-1135

## Beschreibung

Die Erfindung betrifft ein optoelektronisches Bauelement nach dem Oberbegriff des Patentanspruchs 1 und ein Verfahren zu dessen Herstellung.

Die Kontaktierung strahlungsemittierender optoelektronischer Bauelemente erfolgt in der Regel durch das Aufbringen eines metallischen Anschlusskontakts auf den Halbleiterchip, der die aktive Zone enthält. Oftmals ist die zur Kontaktierung vorgesehene Oberfläche des Halbleiterchips gleichzeitig zur Strahlungsauskopplung vorgesehen, so dass der für die emittierte Strahlung nicht transparente Anschlusskontakt nur auf einen Teilbereich der Oberfläche aufgebracht werden kann.

Insbesondere bei der Herstellung von elektrischen Kontakten auf p-dotierten Halbleiterschichten von III-V-Nitridverbindungshalbleitern tritt dabei das Problem auf, dass die an den Anschlusskontakt angrenzende Halbleiterschicht derart hochohmig ist, dass der Stromfluss durch die aktive Zone im wesentlichen nur durch die Bereiche direkt unterhalb des Anschlusskontakts erfolgt. Dies wirkt sich negativ auf die Helligkeit und die Effizienz des optoelektronischen Bauelements aus.

Um eine niedrige Vorwärtsspannung und eine gleichmäßige hohe Helligkeit über die gesamte Chipfläche zu erzielen, ist eine weitgehend homogene Stromdichte über die Chipfläche wünschenswert. Um eine möglichst homogene laterale Stromdichteverteilung zu erzielen, ist beispielsweise aus der EP 0 551 001 B1 bekannt, zwischen dem Anschlusskontakt und der darunter liegenden Halbleiterschicht eine möglichst dicke Stromaufweitungsschicht mit guter Leitfähigkeit, die für die emittierte Strahlung transparent ist, einzufügen.

Derartige Stromaufweitungsschichten sollten einen ohmschen Kontakt mit dem Halbleiter gewährleisten sowie transparent, temperatur- und alterungsstabil sein. Weiterhin sollte sich das Aufbringen einer solchen Stromaufweitungsschicht in einfacher Weise in den Herstellungsprozess des optoelektronischen Bauelements integrieren lassen. Diese vielfachen Anforderungen schränken die Materialauswahl für derartige Stromaufweitungsschichten erheblich ein.

Eine homogene Stromdichte über die Chipfläche kann insbesondere durch eine großflächige Stromaufweitungsschicht, die bis an die Seitenflanken des Halbleiterchips heranreicht, erreicht werden. Dabei besteht jedoch die Gefahr, dass aufgrund von elektrostatischen Entladungen (ESD - Electro Static Discharge) Spannungsüberschläge an den Seitenflanken des Halbleiterchips auftreten. Diese Gefahr besteht insbesondere bei strahlungsemittierenden Halbleiterchips auf der Basis von III-V-Nitridverbindungshalbleitern, da bei diesen vergleichsweise hohe interne elektrische Felder auftreten.

US 2002/0036286 A1 offenbart eine doppelschichtige Stromaufweitungsstruktur.

Der Erfindung liegt die Aufgabe zugrunde, ein optoelektronisches Bauelement anzugeben, das sich durch eine möglichst homogene laterale Verteilung der Stromdichte und gleichzeitig durch eine hohe ESD-Festigkeit auszeichnet.

Diese Aufgabe wird gemäß der Erfindung durch ein optoelektronisches Bauelement mit den Merkmalen des Patentanspruchs 1 gelöst. Ein Verfahren zum Herstellen eines derartigen optoelektronischen Bauelements wird im Patentanspruch 17 angegeben. Vorteilhafte Ausgestaltungen und Weiterbildungen der Erfindung sind Gegenstand der abhängigen Ansprüche.

Ein optoelektronisches Bauelement mit einem Halbleiterchip, der eine Halbleiterschichtenfolge mit einer strahlungsemittierenden aktive Zone enthält, wobei die Halbleiterschichtenfolge Seitenflanken aufweist, und einem Anschlusskontakt zur Stromeinprägung in die aktive Zone, enthält gemäß der Erfindung zwischen der Halbleiterschichtenfolge und dem Anschlusskontakt eine erste, an eine Halbleiterschicht der Halbleiterschichtenfolge angrenzende Stromaufweitungsschicht, und eine zweite Stromaufweitungsschicht, wobei die erste Stromaufweitungsschicht einen größeren Schichtwiderstand als die zweite Stromaufweitungsschicht aufweist und einen ohmschen Kontakt mit der angrenzenden Halbleiterschicht ausbildet, und die zweite Stromaufweitungsschicht auf einen Teilbereich der ersten Stromaufweitungsschicht aufgebracht ist, der von den Seitenflanken beabstandet ist, derart, dass der Teilbereich nicht an die Seitenflanken angrenzt.

Der Schichtwiderstand ist eine auf eine quadratische Einheitsfläche bezogene Größe und wird daher häufig auch als Square-Widerstand bezeichnet oder in der mit einem Zusatz versehenen Einheit Ω/square angegeben. Für eine Probe mit quadratischer Form und konstanter Dicke d beträgt der Schichtwiderstand Rₛ = ρ / d, wobei ρ der spezifische Widerstand des Materials ist. Im folgenden wird für den Schichtwiderstand durchgehend die SI-Einheit Ω ohne kennzeichnende Zusätze verwendet.

Durch den im Vergleich zur zweiten Stromaufweitungsschicht größeren, bevorzugt mindestens 2 mal so großen und besonders bevorzugt mindestens 10 mal so großen Schichtwiderstand der ersten Stromaufweitungsschicht und einem Abstand der zweiten Stromaufweitungsschicht zu den Seitenflanken der Halbleiterschichtenfolge, der bevorzugt mindestens 100 nm, besonders bevorzugt mehr als 1 *µ*m beträgt, wird die Gefahr von Spannungsüberschlägen an den Seitenflanken des Halbleiterchips vorteilhaft vermindert und damit die ESD-Festigkeit erhöht.

Die erste Stromaufweitungsschicht weist vorteilhafterweise in lateraler Richtung einen Abstand von weniger als 3 *µ*m zu den Seitenflanken der Halbleiterschichtenfolge auf oder reicht sogar ganz bis an die Seitenflanken heran. Insbesondere kann die erste Stromaufweitungsschicht auch ganzflächig auf die Halbleiterschichtenfolge aufgebracht sein. Dadurch wird vorteilhaft eine homogene Verteilung der Stromdichte innerhalb des optoelektronischen Bauelements bis zu den Seitenflanken erreicht, wodurch die Helligkeit und die Effizienz des optoelektronischen Bauelements erhöht werden.

Der Schichtwiderstand der ersten Stromaufweitungsschicht beträgt bevorzugt mehr als 1000 Ω, um eine hohe ESD-Festigkeit zu erzielen. Ein derart hoher Schichtwiderstand kann beispielsweise dadurch erzielt werden, dass eine sehr dünne erste Stromaufweisungsschicht verwendet wird. Bevorzugt ist die erste Stromaufweitungsschicht weniger als 2 nm dick.

Um im Normalbetrieb eines optoelektronischen Bauelements eine möglichst homogene Verteilung der Stromdichte sicherzustellen, sollte der Schichtwiderstand der zweiten Stromaufweitungsschicht möglichst niedrig sein. Bevorzugt beträgt der Schichtwiderstand der zweiten Stromaufweitungsschicht zwischen 1 Ω und 50 Ω.

Der zweiten Stromaufweitungsschicht können vom Halbleiterchip aus gesehen eine oder auch mehrere weitere Stromaufweitungsschichten nachfolgen. Die mehreren Stromaufweitungsschichten sind bevorzugt stufenförmig aufeinander aufgebracht, so dass jede nachfolgende Stromaufweitungsschicht nur einen Teilbereich der ihr vorangehenden Stromaufweitungsschicht bedeckt.

Die Erfindung ist nicht auf eine bestimmte Ausführungsform der Halbleiterschichtenfolge beschränkt, insbesondere kann das optoelektronische Bauelement eine beliebige für LEDs oder Laserdioden bekannte Halbleiterschichtenfolge aufweisen. Besonders vorteilhaft ist die Erfindung für optoelektronische Bauelemente, bei denen die Halbleiterschichtenfolge ein III-V-Nitridverbindungshalbleitermaterial enthält. Bei auf diesen Halbleitermaterialen basierenden optoelektronischen Bauelementen ist das Risiko eines ESD-Spannungsüberschlags an den Seitenflanken besonders hoch, da bei diesen elektrische Felder mit einer elektrischen Feldstärke von einigen MV/cm auftreten können.

Die an die erste Stromaufweitungsschicht angrenzende Halbleiterschicht kann insbesondere eine p-dotierte Halbleiterschicht eines III-V-Nitridverbindungshalbleiters sein. Bei p-dotierten III-V-Nitridverbindungshalbleiters ist die Querleitfähigkeit derartig gering, dass sich ohne das Einfügen von Stromaufweitungsschichten der Stromfluss im wesentlichen auf einen Bereich unterhalb des Anschlusskontakts beschränken würde, und daher ein großer Teil der emittierten Strahlung durch Absorption im Anschlusskontakt verloren gehen würde.

Insbesondere kann die Halbleiterschichtenfolge das III-V-Nitridverbindungshalbleitermaterial AlₓGa_{y}In_{1-x-y}N, wobei 0 ≤ x ≤ 1, 0 ≤ y ≤ 1 und x + y ≤ 1 ist, enthalten.

Die erste Stromaufweitungsschicht enthält bevorzugt eines der Materialien Platin, Palladium oder Nickel. Diese sind vorteilhaft zur Ausbildung eines ohmschen Kontakts auf einem III-V-Nitridverbindungshalbleitermaterial geeignet. Dadurch, dass der ohmsche Kontakt mit der ersten Stromaufweitungsschicht hergestellt wird, besteht bei der zweiten Stromaufweisungsschicht eine größere Freiheit der Materialauswahl. Diese kann insbesondere Au, Pd, ZnO oder ITO enthalten.

Die Erfindung ist insbesonders vorteilhaft für optoelektronische Bauelemente, die eine Halbleiterschichtenfolge mit einer Breite von 200 *µ*m oder weniger aufweisen, da bei diesen Bauelementen eine möglichst homogene Verteilung der Stromdichte bis in die Nähe der Seitenflanken notwendig ist, um die verhältnismäßig geringe Fläche des Halbleiterchips effektiv auszunutzen.

Bei einem Verfahren zum Herstellen eines erfindungsgemäßen optoelektronischen Bauelements wird ein Substrat bereitgestellt, eine Halbleiterschichtenfolge auf das Substrat aufgebracht, mindestens zwei Stromaufweitungsschichten auf die Halbleiterschichtenfolge aufgebracht und anschließend eine Maskenschicht auf die Stromaufweitungsschichten aufgebracht und strukturiert.

Vor dem Aufbringen der Maskenschicht kann vorteilhaft eine Schutzschicht aus einem Siliziumoxid, einem Siliziumnitrid oder einem Siliziumoxidnitrid auf die zuletzt aufgebrachte Stromaufweitungsschicht aufgebracht werden, um die Halbleiterschichtenfolge beim Entfernen der Maskenschicht zu schützen. Diese Schutzschicht kann in einem später folgenden Ätzprozess entfernt werden.

Das Strukturieren der ersten Stromaufweitungsschicht erfolgt durch einen Ätzprozess, bevorzugt durch einen Trockenätzprozess, bei dem die Seitenflanken der Maskenschicht weniger unterätzt werden als beim im folgenden beschriebenen Strukturieren der zweiten Stromaufweitungsschicht. Bevorzugt werden die Seitenflanken der Maskenschicht beim Strukturieren der ersten Stromaufweitungsschicht überhaupt nicht unterätzt. Besonders vorteilhaft ist es, wenn bei diesem Verfahrensschritt, also mit der gleichen Maskenschicht, auch die Halbleiterschichtenfolge strukturiert wird. Der Herstellungsaufwand wird dadurch reduziert.

Die zweite Stromaufweitungsschicht wird durch einen Ätzprozess strukturiert, bei dem die Seitenflanken der Maskenschicht unterätzt werden. Bevorzugt erfolgt dies mit einem nasschemischen Ätzprozess. Dabei wird ein Ätzmittel verwendet, durch das die erste Stromaufweitungsschicht und die Halbleiterschichtenfolge nicht geätzt werden. Die gegebenenfalls aufgebrachte Schutzschicht wird anschließend in einem weiteren Ätzprozess von den Stromaufweitungsschichten entfernt.

Die angegebenen Verfahrensschritte müssen nicht notwendigerweise in der zuvor beschriebenen Reihenfolge durchgeführt werden. Insbesondere kann auch zuerst die zweite Stromaufweitungsschicht mittels einem Ätzverfahren, bei dem die Maskenschicht unterätzt wird, und anschließend die erste Stromaufweitungsschicht mit einem Ätzverfahren, bei dem die Maskenschicht weniger oder gar nicht unterätzt wird, strukturiert werden.

Die Erfindung wird im folgenden anhand von drei Ausführungsbeispielen im Zusammenhang mit den Figuren 1 bis 3 näher erläutert.

Es zeigen:
- Figur 1: eine schematische Darstellung eines Querschnitts durch ein erstes Ausführungsbeispiel eines optoelektronischen Bauelements gemäß der Erfindung,
- Figur 2: eine schematische Darstellung eines Querschnitts durch ein zweites Ausführungsbeispiel eines optoelektronischen Bauelements gemäß der Erfindung und
- Figur 3: schematische Darstellungen von Zwischenschritten eines erfindungsgemäßen Verfahrens zur Herstellung eines optoelektronischen Bauelements.

Gleiche oder gleichwirkende Elemente sind in den Figuren mit den gleichen Bezugszeichen versehen.

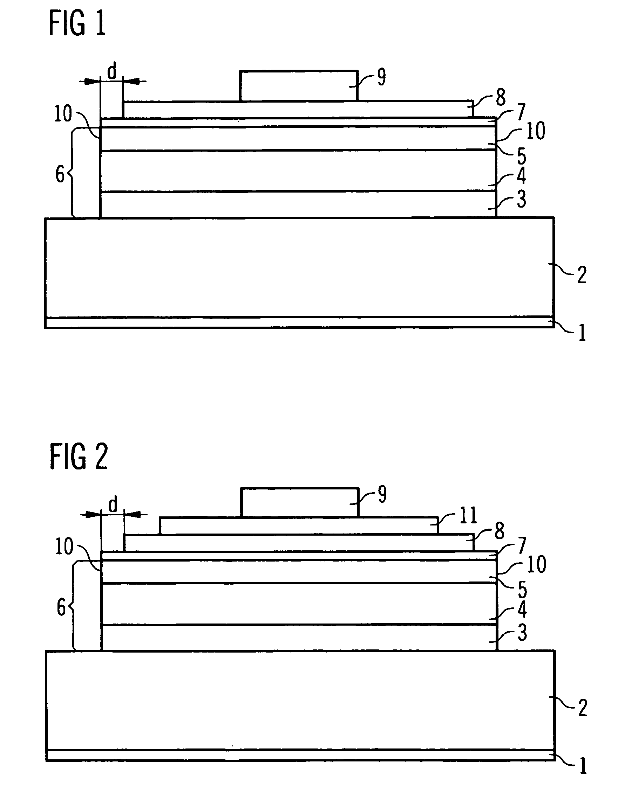

Das in Figur 1 dargestellte erfindungsgemäße optoelektronische Bauelement enthält ein Substrat 2, auf das eine Halbleiterschichtenfolge 6 aufgebracht ist. Die Halbleiterschichtenfolge 6 enthält mindestens eine n-dotierte Halbleiterschicht 3 und mindestens eine p-dotierte Halbleiterschicht 5, zwischen denen eine aktive Zone 4 ausgebildet ist. Die Halbleiterschichtenfolge 6 weist eine Mesastruktur auf, die in lateraler Richtung durch die Seitenflanken 10 begrenzt ist. Die Seitenflanken 10 müssen nicht, wie in Figur 1 dargestellt, senkrecht zu der Halbleiterschichtenfolge 6 verlaufen, sondern können alternativ auch schräg zu der Halbleiterschichtenfolge 6 verlaufen oder gekrümmt sein.

Auf die p-dotierte Halbleiterschicht 5 ist eine erste Stromaufweitungsschicht 7 aufgebracht. Auf einen Teilbereich der ersten Stromaufweitungsschicht 7, der in lateraler Richtung einen Abstand d von mehr als 100 nm zu den Seitenflanken 10 der Mesastruktur aufweist, ist eine zweite Stromaufweitungsschicht 8 aufgebracht. Der Schichtwiderstand der ersten Stromaufweitungsschicht 7 ist um mindestens einen Faktor 10 größer als der Schichtwiderstand der zweiten Stromaufweitungsschicht 8. Zur elektrischen Kontaktierung des optoelektronischen Bauelements sind ein erster Anschlusskontakt 1 auf der von der Halbleiterschichtenfolge 6 abgewandten Seite des Substrats 2 und ein zweiter Anschlusskontakt 9 auf einem Teilbereich der zweiten Stromaufweitungsschicht 8 vorgesehen.

Eine derartige stufenförmige Anordnung mindestens zweier Stromaufweitungsschichten 7, 8 zwischen der Halbleiterschichtenfolge 6 und dem Anschlusskontakt 9 wirkt sich in mehrfacher Hinsicht vorteilhaft auf den Betrieb des strahlungsemittierenden optoelektronischen Bauelements aus. Einerseits wird bei dem Betrieb des strahlungsemittierenden optoelektronischen Bauelements mit dem Betriebsstrom, beispielsweise etwa 20 mA, eine vergleichsweise homogene Stromdichteverteilung bis nahe an die Seitenflanken der Mesastruktur 10 erreicht. Dadurch kann eine hohe Helligkeit des Bauelements und eine verhältnismäßig niedrige Vorwärtsspannung erreicht werden.

Durch den hohen Schichtwiderstand der bis an die Seitenflanken des Halbleiterchips 10 heranreichenden ersten Stromaufweitungsschicht 7 wird gleichzeitig die Gefahr von Spannungsüberschlägen durch ESD-Spannungspulse an den Seitenflanken 10 vermindert. Vorteilhafterweise nimmt die Stromdichte innerhalb der zweiten Stromaufweitungsschicht 8 bei einem Betriebsstrom von beispielsweise etwa 20 mA um etwa 5 % bis 30 % von der Mitte bis zum Rand hin ab. Dieser Stromdichtegradient verstärkt sich innerhalb der ersten Stromaufweitungsschicht 7. Bei im Falle eines ESD-Pulses auftretenden hohen Stromstärken von zum Beispiel etwa 1 A tritt ist dann Abnahme der Stromdichte zu den Seitenflanken 10 der Mesastruktur hin ausreichend groß, dass keine Überschläge an den Seitenflanken 10 erfolgen.

Das in Figur 2 dargestellte Ausführungsbeispiel der Erfindung unterscheidet sich von dem in Figur 1 dargestellten dadurch, dass zwischen der zweiten Stromaufweitungsschicht 8 und dem Anschlusskontakt 9 eine dritte Stromaufweitungsschicht 11 enthalten ist, die auf einen Teilbereich der zweiten Stromaufweitungsschicht 8 aufgebracht ist. Im Rahmen der Erfindung können der dritten Stromaufweitungsschicht 11 in der Richtung zum zweiten Anschlusskontakt 9 hin auch noch weitere Stromaufweitungsschichten nachgeordnet sein, wobei es vorteilhaft ist, wenn jede nachgeordnete Stromaufweitungsschicht jeweils einen Teilbereich der ihr vorangehenden Stromaufweitungsschicht bedeckt und einen geringeren Schichtwiderstand aufweist als die ihr vorangehende Stromaufweitungsschicht. Diese stufenförmige Anordnung mehrerer Stromaufweitungsschichten 7, 8, 11 bewirkt eine besonders homogene laterale Verteilung der Stromdichte in dem optoelektronischen Bauelement.

Bei einem strahlungsemittierenden optoelektronischen Bauelement, bei dem die emittierte Strahlung durch die Stromaufweitungsschichten ausgekoppelt wird, sollten die Stromaufweitungsschichten zumindest semitransparent für die emittierte Strahlung sein. Für die direkt an die Halbleiterschichtenfolge 6 angrenzende erste Stromaufweitungsschicht 7 besteht weiterhin die Anforderung, dass sie einen ohmschen Kontakt zu der angrenzenden Halbleiterschicht 5 herstellen soll. Die erste Stromaufweitungsschicht 7 ist bevorzugt eine weniger als 2 nm dicke Metallschicht, die beispielsweise Pt, Pd oder Ni enthält. Bevorzugte Materialien für die zweite Stromaufweitungsschicht sind Au, Pd, ZnO und ITO.

Die Stromaufweitungsschichten 7, 8, 11 können auch nur punktuell aufgebracht sein oder beispielsweise aufgrund einer sehr geringen Dicke eine netz- oder inselförmige Struktur aufweisen. In diesem Fall müssen innerhalb der Stromaufweitungsschichten in lateraler Richtung nicht notwendigerweise geschlossene Strompfade ausgebildet sein.

Eine semitransparente Ausführung der Stromaufweitungsschichten 7, 8, 11 ist sinnvoll, wenn durch die von den Stromaufweitungsschichten bedeckten Bereiche Strahlung aus dem optoelektronischen Bauelement ausgekoppelt werden soll. Alternativ können eine oder mehrere der Stromaufweitungsschichten 7, 8, 11 auch als spiegelnde Schichten ausgeführt werden, beispielsweise um Absorption emittierter Strahlung im Anschlusskontakt 9 zu verhindern. Diese Ausführung ist auch dann vorteilhaft, wenn es sich bei dem optoelektronischen Bauelement um eine LED handelt, bei der die Strahlung in lateraler Richtung oder durch das Substrat 2 ausgekoppelt wird.

Im Rahmen der Erfindung können eine oder mehrere der Stromaufweitungsschichten 7, 8, 11 in lateraler Richtung eine veränderliche Schichtdicke und/oder Zusammensetzung aufweisen. Dies ist eine weitere vorteilhafte Möglichkeit, um die Stromdichteverteilung in lateraler Richtung gezielt einzustellen.

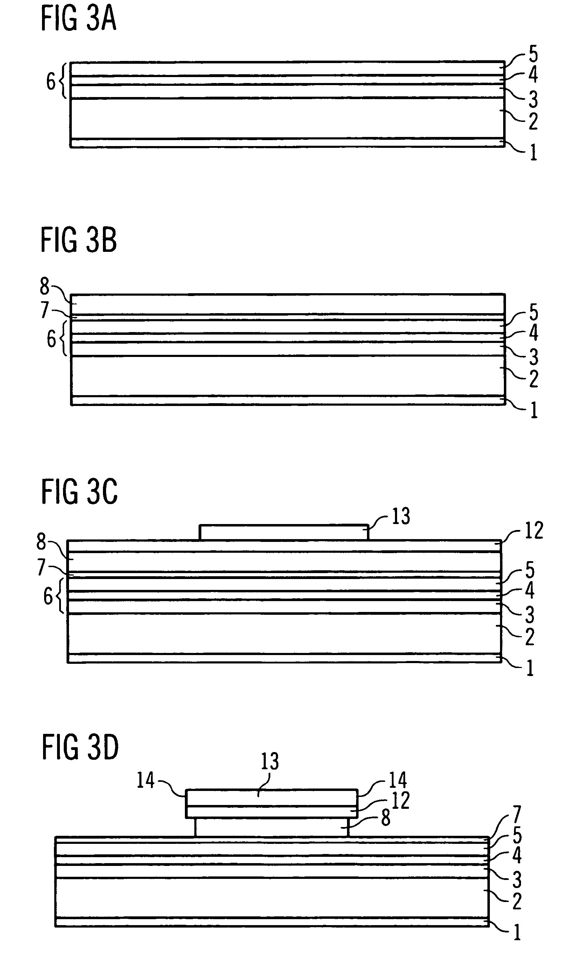

In den Figuren 3a bis 3g sind verschiedene Zwischenstufen eines erfindungsgemäßen Verfahrens zum Herstellen eines optoelektronischen Bauelements dargestellt.

Figur 3a zeigt ein Halbleitersubstrat 2, auf das eine Halbleiterschichtenfolge 6 aufgebracht ist, die mindestens eine n-dotierte Halbleiterschicht 3 und mindestens eine p-dotierte Halbleiterschicht 5 enthält, zwischen denen eine strahlungsemittierende aktive Zone 4 ausgebildet ist. Die Oberfläche der Halbleiterschichtenfolge 6 kann vor dem nachfolgenden Aufbringen der Stromaufweitungsschichten aufgeraut werden. Die von der Halbleiterschichtenfolge 6 abgewandte Rückseite des Substrats 2 ist mit einem ersten Anschlusskontakt 1 versehen.

Bei dem in Figur 3b dargestellten Zwischenschritt werden eine erste Stromaufweitungsschicht 7, beispielsweise eine etwa 0,3 nm dicke Platinschicht, und eine zweite Stromaufweitungsschicht 8, beispielsweise eine etwa 6 nm dicke Goldschicht, auf die Halbleiterschichtenfolge 6 aufgebracht.

Zur Strukturierung der Stromaufweitungsschichten 7, 8 wird, wie in Figur 3c dargestellt, zunächst eine Maskenschicht 13, beispielsweise ein Photolackschicht, aufgebracht. Vorteilhaft wird vor dem Aufbringen der Maskenschicht 13 eine Schutzschicht 12 auf die zweite Stromaufweitungsschicht 8 aufgebracht. Die Schutzschicht 12 ist zum Beispiel etwa 150 nm dick. Bevorzugt enthält sie ein Siliziumoxid, ein Siliziumnitrid oder ein Siliziumoxidnitrid.

Bei dem in Figur 3d dargestellten Zwischenschritt sind die zweite Stromaufweitungsschicht 8 und die Schutzschicht 12 mittels eines nasschemischen Ätzverfahrens, bei dem die Seitenflanken 14 der Maskenschicht 13 unterätzt werden, strukturiert worden. Dabei wird ein Ätzmittel verwendet, durch das die erste Stromaufweitungsschicht 7 nicht oder nur geringfügig angegriffen wird. Das Material der zweiten Stromaufweitungsschicht 8 muss also nasschemisch selektiv zur ersten Stromaufweitungsschicht ätzbar sein.

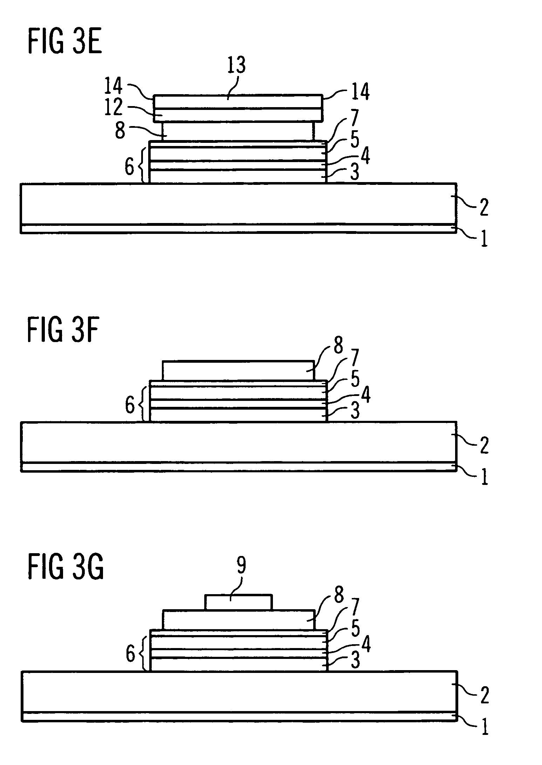

Bevorzugt mit einem Trockenätzprozess wird anschließend die erste Stromaufweitungsschicht 7 strukturiert. Bei dem Trockenätzprozess werden die Seitenflanken 14 der Maskenschicht 13 nur sehr wenig oder überhaupt nicht unterätzt, so dass die Struktur der Maskenschicht 13 auf die erste Stromaufweitungsschicht 7 übertragen wird. Dabei bildet sich eine Stufe zwischen der ersten Stromaufweitungsschicht 7 und der zweiten Stromaufweitungsschicht 8 aus. Besonders vorteilhaft ist es , wenn bei dem Trockenätzprozess gleichzeitig auch die Mesastruktur der Halbleiterschichtenfolge 6 erzeugt wird, so dass die in Figur 3e dargestellte Struktur entsteht. Die Stufe zwischen der ersten Stromaufweitungsschicht 7 und der zweiten Stromaufweitungsschicht 8 soll mindestens so breit sein, dass die zweite Stromaufweitungsschicht einen 8 Abstand von mindestens 100 nm zu den Seitenflanken aufweist. Eventuell kann es dazu erforderlich sein, die zweite Stromaufweitungsschicht 8 nach dem Ausbilden der Mesastruktur nasschemisch nachzuätzen.

Die im Zusammenhang mit den Figuren 3d und 3e erläuterten Verfahrensschritte zum Strukturieren der Stromaufweitungsschichten 7, 8 und der Halbleiterschichtenfolge 6 können in beliebiger Reihenfolge durchgeführt werden, d.h. es kann entweder zuerst die erste Stromaufweitungsschicht und nachfolgend die zweite Stromaufweitungsschicht oder zuerst die zweite Stromaufweitungsschicht und nachfolgend die erste Stromaufweitungsschicht strukturiert werden. Unabhängig von der Reihenfolge der beiden Ätzschritte besteht der Vorteil, dass nur eine phototechnische Strukturierung der Maskenschicht 13 erforderlich ist. Ein zweites Aufbringen und Strukturieren einer Maske, das den Herstellungs- und Justageaufwand deutlich erhöhen würde, ist also nicht erforderlich. Der gesamte Herstellungsaufwand, insbesondere auch der Kostenaufwand, ist bei diesem Verfahren deshalb vergleichsweise gering.

In einem nächsten Verfahrensschritt werden die Schutzschicht 12 und die Maskenschicht 13 in einem weiteren Ätzschritt entfernt. Das Ergebnis dieses Zwischenschritts ist in Figur 3f dargestellt.

Anschließend wird der zweite Anschlusskontakt 9 auf die zweite Stromaufweitungsschicht 8 aufgebracht und strukturiert. Das auf diese Weise entstandene optoelektronische Bauelement gemäß der Erfindung ist in Figur 3g dargestellt.

## Patentansprüche

1. Optoelektronisches Bauelement mit einem Halbleiterchip, der eine Halbleiterschichtenfolge (6) mit einer strahlungsemittierenden aktiven Zone (4) enthält, wobei die Halbleiterschichtenfolge (6) Seitenflanken (10) aufweist, und einem Anschlusskontakt (9) zur Stromeinprägung in die aktive Zone (4), wobei
zwischen der Halbleiterschichtenfolge (6) und dem Anschlusskontakt (9) eine erste, an eine Halbleiterschicht (5) der Halbleiterschichtenfolge (6) angrenzende Stromaufweitungsschicht (7), und eine zweite Stromaufweitungsschicht (8) angeordnet sind, und
die erste Stromaufweitungsschicht (7) einen größeren Schichtwiderstand als die zweite Stromaufweitungsschicht (8) aufweist und einen ohmschen Kontakt mit der angrenzenden Halbleiterschicht (5) ausbildet, **dadurch gekennzeichnet, dass**
die zweite Stromaufweitungsschicht (8) auf einen Teilbereich der ersten Stromaufweitungsschicht (7) aufgebracht ist, der von den Seitenflanken (10) beabstandet ist.

2. Optoelektronisches Bauelement nach Anspruch 1,
**dadurch gekennzeichnet, dass**
die erste Stromaufweitungsschicht (7) einen um mindestens einen Faktor 2 größeren Schichtwiderstand als die zweite Stromaufweitungsschicht (8) aufweist.

3. Optoelektronisches Bauelement nach Anspruch 1,
**dadurch gekennzeichnet, dass**
die erste Stromaufweitungsschicht (7) einen um mindestens einen Faktor 10 größeren Schichtwiderstand als die zweite Stromaufweitungsschicht (8) aufweist.

4. Optoelektronisches Bauelement nach einem der vorhergehenden Ansprüche,
**dadurch gekennzeichnet, dass**
die zweite Stromaufweit-u-ngsschicht (8) in lateraler Richtung einen Abstand d von mindestens 100 nm zu den Seitenflanken (10) aufweist.

5. Optoelektronisches Bauelement nach einem der vorhergehenden Ansprüche,
**dadurch gekennzeichnet, dass**
die zweite Stromaufweitungsschicht (8) in lateraler Richtung einen Abstand d von mindestens 1 µm zu den Seitenflanken (10) aufweist.

6. Optoelektronisches Bauelement nach einem der vorhergehenden Ansprüche,
**dadurch gekennzeichnet, dass**
die erste Stromaufweitungsschicht (7) in lateraler Richtung einen Abstand d von weniger als 3 µm zu den Seitenflanken (10) aufweist oder sogar ganz bis an die Seitenflanken (10) heranreicht.

7. Optoelektronisches Bauelement nach einem der vorhergehenden Ansprüche,
**dadurch gekennzeichnet, dass**
die erste Stromaufweitungsschicht (7) einen Schichtwiderstand von mindestens 1000 Ω aufweist.

8. Optoelektronisches Bauelement nach einem der vorhergehenden Ansprüche,
**dadurch gekennzeichnet, dass**
die zweite Stromaufweitungsschicht (8) einen Schichtwiderstand zwischen 1 Ω und 50 Ω aufweist.

9. Optoelektronisches Bauelement nach einem der vorhergehenden Ansprüche,
**dadurch gekennzeichnet, dass**
die erste Stromaufweitungsschicht (7) weniger als 2 nm dick ist.

10. Optoelektronisches Bauelement nach einem der vorhergehenden Ansprüche,
**dadurch gekennzeichnet, dass**
der zweiten Stromaufweitungsschicht (8) von der Halbleiterschichtenfolge (6) aus gesehen mindestens eine weitere Stromaufweitungsschicht (11) nachfolgt.

11. Optoelektronisches Bauelement nach einem der vorhergehenden Ansprüche,
**dadurch gekennzeichnet, dass**
die Halbleiterschichtenfolge (6) ein III-V-Nitridverbindungshalbleitermaterial enthält.

12. Optoelektronisches Bauelement nach Anspruch 11,
**dadurch gekennzeichnet, dass**
das III-V-Nitridverbindungshalbleitermaterial AlₓGa_{y}In_{1-x-y}N umfasst, wobei 0 ≤ x ≤ 1, 0 ≤ y ≤ 1 und x+y ≤ 1 ist.

13. Optoelektronisches Bauelement nach einem der vorhergehenden Ansprüche,
**dadurch gekennzeichnet, dass**
die an die erste Stromaufweitungsschicht (7) angrenzende Halbleiterschicht (5) p-dotiert ist.

14. Optoelektronisches Bauelement nach einem der vorhergehenden Ansprüche,
**dadurch gekennzeichnet, dass**
die erste Stromaufweitungsschicht (7) Pt, Pd oder Ni enthält.

15. Optoelektronisches Bauelement nach einem der vorhergehenden Ansprüche,
**dadurch gekennzeichnet, dass**
die zweite Stromaufweitungsschicht (8) Au, Pd, ZnO oder ITO enthält.

16. Optoelektronisches Bauelement nach einem der vorhergehenden Ansprüche,
**dadurch gekennzeichnet, dass**
die Halbleiterschichtenfolge (6) eine Breite von 200 µm oder weniger aufweist.

17. Verfahren zum Herstellen eines optoelektronischen Bauelements nach einem der Ansprüche 1 bis 16, **gekennzeichnet durch** die Verfahrensschritte
a) Bereitstellen eines Substrats (2),
b) Aufbringen der Halbleiterschichtenfolge (6) auf das Substrat,
c) Aufbringen der mindestens zwei Stromaufweitungsschichten (7,8) auf die Halbleiterschichtenfolge (6),
d) Aufbringen und Strukturieren einer Maskenschicht (13),
e) Strukturieren der zweiten Stromaufweitungsschicht (8) mit einem Ätzprozess, bei dem Seitenflanken (14) der Maskenschicht (13) unterätzt werden,
f) Strukturieren der ersten Stromaufweitungsschicht (7) mit einem Ätzprozess, bei dem die Seitenflanken (14) der Maskenschicht (13) zumindest weniger unterätzt werden als beim Strukturieren der zweiten Stromaufweitungsschicht (8), und
g) Entfernen der Maskenschicht (13).

18. Verfahren nach Anspruch 17,
**dadurch gekennzeichnet, dass**
bei dem Ätzprozess im Verfahrensschritt f) auch die Halbleiterschichtenfolge (6) strukturiert wird.

19. Verfahren nach Anspruch 17 oder 18,
**dadurch gekennzeichnet, dass**
das Strukturieren der zweiten Stromaufweitungsschicht (8) nach dem Strukturieren der ersten Stromaufweitungsschicht (7) erfolgt.

20. Verfahren nach einem der Ansprüche 17 bis 19,
**dadurch gekennzeichnet, dass**
das Strukturieren der zweiten Stromaufweitungsschicht (8) mit einem nasschemischen Ätzprozess erfolgt.

21. Verfahren nach einem der Ansprüche 17 bis 20,
**dadurch gekennzeichnet, dass**
das Strukturieren der ersten Stromaufweitungsschicht (7) und/oder der Halbleiterschichtenfolge (6) mit einem Trockenätzprozess erfolgt.

22. Verfahren nach einem der Ansprüche 17 bis 21,
**dadurch gekennzeichnet, dass**
zwischen den Verfahrensschritten b) und c) eine Schutzschicht (12) auf die zuletzt aufgebrachte Stromaufweitungsschicht (8) aufgebracht wird und die Schutzschicht (12) bei dem Verfahrensschritt g) mit der Maskenschicht (13) entfernt wird.

23. Verfahren nach Anspruch 22,
**dadurch gekennzeichnet, dass**
die Schutzschicht (12) ein Siliziumoxid, ein Siliziumnitrid oder ein Siliziumoxidnitrid enthält.

## Claims

1. Optoelectronic component having a semiconductor chip containing a semiconductor layer sequence (6) with a radiation-emitting active zone (4), the semiconductor layer sequence (6) having sidewalls (10), and a connection contact (9) for impressing current into the active zone (4), wherein a first current spreading layer (7) adjoining a semiconductor layer (5) of the semiconductor layer sequence (6) and a second current spreading layer (8) being arranged between the semiconductor layer sequence (6) and the connection contact (9), and the first current spreading layer (7) has a larger sheet resistance than the second current spreading layer (8) and forms an ohmic contact with the adjoining semiconductor layer (5),
**characterized in that**
the second current spreading layer (8) is applied to a partial region of the first current spreading layer (7) which is at a distance from the sidewalls (10).

2. Optoelectronic component according to claim 1,
**characterized in that**
the first current spreading layer (7) has a sheet resistance that is at least a factor of 2 greater than that of the second current spreading layer (8) .

3. Optoelectronic component according to claim 1,
**characterized in that**
the first current spreading layer (7) has a sheet resistance that is at least a factor of 10 greater than that of the second current spreading layer (8) .

4. Optoelectronic component according to one of the preceding claims,
**characterized in that**
the second current spreading layer (8) is at a distance d of at least 100 nm from the sidewalls (10) in the lateral direction.

5. Optoelectronic component according to one of the preceding claims,
**characterized in that**
the second current spreading layer (8) is at a distance d of at least 1 µm from the sidewalls (10) in the lateral direction.

6. Optoelectronic component according to one of the preceding claims,
**characterized in that**
the first current spreading layer (7) is at a distance d of less than 3 µm from the sidewalls (10) in the lateral direction or even reaches right up to the sidewalls (10).

7. Optoelectronic component according to one of the preceding claims,
**characterized in that**
the first current spreading layer (7) has a sheet resistance of at least 1000 Ω.

8. Optoelectronic component according to one of the preceding claims,
**characterized in that**
the second current spreading layer (8) has a sheet resistance of between 1 Ω and 50 Ω.

9. Optoelectronic component according to one of the preceding claims,
**characterized in that**
the first current spreading layer (7) is less than 2 nm thick.

10. Optoelectronic component according to one of the preceding claims,
**characterized in that**
the second current spreading layer (8) is succeeded by at least one further current spreading layer (11) as seen from the semiconductor layer sequence (6) .

11. Optoelectronic component according to one of the preceding claims,
**characterized in that**
the semiconductor layer sequence (6) contains a III-V nitride compound semiconductor material.

12. Optoelectronic component according to claim 11,
**characterized in that**
the III-V nitride compound semiconductor material comprises AlₓGa_{y}In_{1-x-y}N, where 0 ≤ x ≤ 1, 0 ≤ y ≤ 1 and x+y ≤ 1.

13. Optoelectronic component according to one of the preceding claims,
**characterized in that**
the semiconductor layer (5) adjoining the first current spreading layer (7) is p-doped.

14. Optoelectronic component according to one of the preceding claims,
**characterized in that**
the first current spreading layer (7) contains Pt, Pd or Ni.

15. Optoelectronic component according to one of the preceding claims,
**characterized in that**
the second current spreading layer (8) contains Au, Pd, ZnO or ITO.

16. Optoelectronic component according to one of the preceding claims,
**characterized in that**
the semiconductor layer sequence (6) has a width of 200 µm or less.

17. Method for producing an optoelectronic component according to one of claims 1 to 16,
**characterized by** the method steps of
a) providing a substrate (2),
b) applying the semiconductor layer sequence (6) to the substrate,
c) applying the at least two current spreading layers (7, 8) to the semiconductor layer sequence (6),
d) applying and patterning a mask layer (13),
e) patterning the second current spreading layer (8) by means of an etching process during which sidewalls (14) of the mask layer (13) are undercut,
f) patterning the first current spreading layer (7) by means of an etching process during which the sidewalls (14) of the mask layer (13) are undercut at least to a lesser extent than during the patterning of the second current spreading layer (8) , and
g) removing the mask layer (13).

18. Method according to claim 17,
**characterized in that**
the semiconductor layer sequence (6) is also patterned during the etching process in method step f) .

19. Method according to claim 17 or 18,
**characterized in that**
the patterning of the second current spreading layer (8) is effected after the patterning of the first current spreading layer (7).

20. Method according to one of claims 17 to 19,
**characterized in that**
the patterning of the second current spreading layer (8) is effected by means of a wet-chemical etching process.

21. Method according to one of claims 17 to 20,
**characterized in that**
the patterning of the first current spreading layer (7) and/or of the semiconductor layer sequence (6) is effected by means of a dry etching process.

22. Method according to one of claims 17 to 21,
**characterized in that**
between method steps b) and c), a protective layer (12) is applied to the current spreading layer (8) applied last and the protective layer (12) is removed with the mask layer (13) in method step g).

23. Method according to claim 22,
**characterized in that**
the protective layer (12) contains a silicon oxide, a silicon nitride or a silicon oxide-nitride.

## Revendications

1. Dispositif optoélectronique comportant une puce de semi-conducteur, qui contient une succession de couches de semi-conducteur (6) avec une zone active (4) émettant un rayonnement, dans lequel la succession de couches de semi-conducteur (6) présente des flancs latéraux (10), et un contact de connexion (9) pour empreindre le courant dans la zone active (4), dans lequel entre la succession de couches de semi-conducteur (6) et le contact de connexion (9) une première couche de diffusion de courant (7) contiguë à une couche de semi-conducteur (5) de la succession de couches de semi-conducteur (6) et une deuxième couche de diffusion de courant (8) sont disposées, et la première couche de diffusion de courant (7) présente une résistance de couche plus grande que la deuxième couche de diffusion de courant (8) et réalise un contact ohmique avec la couche de semi-conducteur (5) contiguë,
**caractérisé en ce que**
la deuxième couche de diffusion de courant (8) est appliquée sur une zone partielle de la première couche de diffusion de courant (7), qui est espacée des flancs latéraux (10).

2. Dispositif optoélectronique selon la revendication 1,
**caractérisé en ce que**
la première couche de diffusion de courant (7) présente une résistance de couche plus grande d'au moins un facteur 2 que la deuxième couche de diffusion de courant (8).

3. Dispositif optoélectronique selon la revendication 1,
**caractérisé en ce que**
la première couche de diffusion de courant (7) présente une résistance de couche plus grande d'au moins un facteur 10 que la deuxième couche de diffusion de courant (8).

4. Dispositif optoélectronique selon une des revendications précédentes,
**caractérisé en ce que**
la deuxième couche de diffusion de courant (8) présente dans la direction latérale un espacement d d'au moins 100 nm par rapport aux flancs latéraux (10).

5. Dispositif optoélectronique selon une des revendications précédentes,
**caractérisé en ce que**
la deuxième couche de diffusion de courant (8) présente dans la direction latérale un espacement d d'au moins 1 µm par rapport aux flancs latéraux (10) .

6. Dispositif optoélectronique selon une des revendications précédentes,
**caractérisé en ce que**
la première couche de diffusion de courant (7) présente dans la direction latérale un espacement d inférieur à 3 µm par rapport aux flancs latéraux (10) ou arrive même totalement jusqu'aux flancs latéraux (10).

7. Dispositif optoélectronique selon une des revendications précédentes,
**caractérisé en ce que**
la première couche de diffusion de courant (7) présente une résistance de couche d'au moins 1000 Ω .

8. Dispositif optoélectronique selon une des revendications précédentes,
**caractérisé en ce que**
la deuxième couche de diffusion de courant (8) présente une résistance de couche comprise entre 1 Ω et 50 Ω.

9. Dispositif optoélectronique selon une des revendications précédentes,
**caractérisé en ce que**
la première couche de diffusion de courant (7) est épaisse de moins de 2 nm.

10. Dispositif optoélectronique selon une des revendications précédentes,
**caractérisé en ce que**
vu d'après la succession de couches de semi-conducteur (6), au moins une couche de diffusion de courant supplémentaire (11) succède à la deuxième couche de diffusion de courant (8).

11. Dispositif optoélectronique selon une des revendications précédentes,
**caractérisé en ce que**
la séquence de couches de semi-conducteur (6) contient un matériau semi-conducteur de liaison au nitrure III-V.

12. Dispositif optoélectronique selon la revendication 11,
**caractérisé en ce que**
le matériau semi-conducteur de liaison au nitrure III-V comprend du AlₓGa_{y}In_{1-x-y}N, dans lequel 0 ≤ x ≤ 1, 0 ≤ y ≤ 1 et x+y ≤ 1.

13. Dispositif optoélectronique selon une des revendications précédentes,
**caractérisé en ce que**
la couche de semi-conducteur (5) contiguë à la première couche de diffusion de courant (7) est p-dopée.

14. Dispositif optoélectronique selon une des revendications précédentes,
**caractérisé en ce que**
la première couche de diffusion de courant (7) contient du Pt, Pd ou Ni.

15. Dispositif optoélectronique selon une des revendications précédentes,
**caractérisé en ce que**
la deuxième couche de diffusion de courant (8) contient du Au, Pd, ZnO ou ITO.

16. Dispositif optoélectronique selon une des revendications précédentes,
**caractérisé en ce que**
la succession de couches de semi-conducteur (6) présente une largeur de 200 µm ou inférieur.

17. Procédé de fabrication d'un dispositif optoélectronique selon une des revendications 1 à 16,
**caractérisé par** les étapes de procédé consistant à :
a) fournir un substrat (2),
b) appliquer la succession de couches de semi-conducteur (6) sur le substrat,
c) appliquer les au moins deux couches de diffusion de courant (7, 8) sur la succession de couches de semi-conducteur (6),
d) appliquer et structurer une couche de masque (13),
e) structurer la deuxième couche de diffusion de courant (8) avec un processus d'attaque chimique, dans lequel les flancs latéraux (14) de la couche de masque (13) sont attaqués chimiquement par-dessous,
f) structurer la première couche de diffusion de courant (7) avec un processus d'attaque chimique, dans lequel les flancs latéraux (14) de la couche de masque (13) sont moins attaqués chimiquement par-dessous que lors de la structuration de la deuxième couche de diffusion de courant (8), et
g) retirer la couche de masque (13).

18. Procédé selon la revendication 17,
**caractérisé en ce que**
dans le cadre du processus d'attaque chimique à l'étape de procédé f), la succession de couches de semi-conducteur (6) est aussi structurée.

19. Procédé selon la revendication 17 ou 18,
**caractérisé en ce que**
la structuration de la deuxième couche de diffusion de courant (8) s'effectue après la structuration de la première couche de diffusion de courant (7).

20. Procédé selon une des revendications 17 à 19,
**caractérisé en ce que**
la structuration de la deuxième couche de diffusion de courant (8) s'effectue avec un processus d'attaque chimique humide.

21. Procédé selon une des revendications 17 à 20,
**caractérisé en ce que**
la structuration de la première couche de diffusion de courant (7) et/ou de la succession de couches de semi-conducteur (6) s'effectue avec un processus d'attaque chimique sec.

22. Procédé selon une des revendications 17 à 21,
**caractérisé en ce que**
entre les étapes de procédé b) et c), une couche de protection (12) est appliquée sur la couche de diffusion de courant (8) appliquée en dernier et la couche de protection (12) est retirée à l'étape de procédé g) avec la couche de masque (13).

23. Procédé selon la revendication 22,
**caractérisé en ce que**
la couche de protection (12) contient un oxyde de silicium, un nitrure de silicium ou un nitrure d'oxyde de silicium.
